(19) Europäisches Patentamt
European Patent Office
Office européen des brevets

(11) EP 1 134 890 A1

(12) **EUROPEAN PATENT APPLICATION**

(43) Date of publication:
19.09.2001 Bulletin 2001/38

(51) Int Cl.[7]: **H03F 1/02**, H03F 1/30

(21) Application number: 00200820.9

(22) Date of filing: 09.03.2000

(84) Designated Contracting States:
AT BE CH CY DE DK ES FI FR GB GR IE IT LI LU MC NL PT SE
Designated Extension States:
AL LT LV MK RO SI

(71) Applicant: ECI Telecom Ltd.
Petach Tikva 49517 (IL)

(72) Inventors:
• Schultz, Levi
D.N. Hashmonaim 73127 (IL)

• Moas, Yaron
Rishon Lezion (IL)

(74) Representative: Curell Aguilà, Marcelino et al
Dr. Ing. M. Curell Sunol I.I. S.L.
Agentes de la Propiedad Industrial
Passeig de Gracia, 65 bis
E-08008 Barcelona (ES)

(54) **Fet gate biasing control device for power amplifier**

(57) A novel closed loop FET biasing circuit featuring a standard logic control format for operational mode switching between operating states of a FET power amplifier. In a preferred embodiment, a FET gate bias control device is provided for configuring a gate bias circuit in a FET power amplifier to accommodate a broad range of output power levels, wherein the configuration is responsive to a command which establishes a FET bias condition. The gate bias control device of the present invention comprises a circuit having a controllable switching unit which connects a plurality of resistors in the source-drain voltage circuit individually or in parallel to provide a multiple of resistance values each corresponding to one of four amplifier operating modes. The controllable switching unit responds to a set of logic control signals, and therefore greatly simplifies the transition between operating modes, while maintaining FET bias conditions which insure operational stability without problems associated with temperature and loading fluctuations.

Figure 4

**Description**

FIELD OF THE INVENTION

The present invention relates to electronic circuits employing field-effect transistors (FET) in amplifier design, and more particularly, to a novel biasing circuit for insuring safe FET operation in applications supporting multiple output power levels and rapid switching between modes of amplifier operation.

BACKGROUND OF THE INVENTION

Power amplifier design using FETs is a well-developed field of electronic circuit design, with the FET defined as a device having a gate electrode and source and drain electrodes. The gate electrode is supplied with a gate bias voltage which in turn sets the bias current (Ids). The bias circuit is completed with the source and drain electrodes, with a source-drain voltage (Vds) applied between them. The optimum operational bias current (Ids) and operational bias voltage (Vds) varies from mode to mode of amplifier operation.
Where FETs are applied in power amplifiers in the telecommunications industry, including portable cellular telephones, a power saving feature is often desirable. This is typically achieved by significant attenuation of the input power level to the amplifier, combined with pinching off the bias current. This shifts the FET operation into a standby mode in response to a transmit/receive command. Additional FET operational states involving adjustment of the input power as well as the source-drain current include a high power state, a reduced power state and a linear, low power state.
Typical design problems associated with operation of a FET in a power amplifier include proper choice of the operating point so that the circuit operates in the linear portion of the FET transfer characteristics in which there is gain. This is known as a biasing problem, in which the gate electrode voltage must be established to allow for dynamic operation within the linear amplification range. This choice is complicated by the need to design the circuit so that the FET does not exceed its maximum power dissipation range, and improper bias design may allow the operating point to shift with temperature in such a way as to burn out the transistor.
The bias problem is further complicated by an unwanted effect known as thermal runaway, which is due to the thermal resistance between the junctions of the transistor and the transistor case. During operation, the power dissipated heats the junction and causes a change in the transistor characteristics, and with unfavourable bias conditions, this in turn causes an increase in the bias current, leading to further overheating. The heat dissipation is also a function of the ambient temperature, and worst case design requires anticipation of these factors.
In telecommunication applications, in addition to the usual problems associated with biasing the FET, the design is further complicated in systems providing time division duplex (TDD) communications and having features such as RF power output control and power saving modes. A complete summary of the design issues is presented as follows:

    1) Power On control - high frequency power FET's inevitably require a positive/negative (dual) power source. When the power supply is applied to or disconnected from the unit, the biasing circuit must guarantee that the negative supply is applied to the FET gate electrode before the positive supply appears at the drain electrode. Otherwise, the FET may draw the maximum Ids and self-destruct from oscillations and inability to dissipate the resultant heat build-up.
    2) Prevent Thermal Runaway- FET biasing circuits which use the "open loop" method (no current sensing feedback) of adjusting Ids, via application of a voltage divider or adjustable voltage applied to the FET gate electrode, are vulnerable to thermal runaway. As mentioned above, this phenomenon occurs when the FET junction reaches a temperature where the gate voltage no longer regulates the channel conductance and the Ids avalanches to a self-destructing $I_{DSS}$ (saturated drain-source current).
    3) Insensitivity to temperature, power supply and device parameter variations - amplifier efficiency, gain and output power capability are all direct functions of Ids. As such, the less sensitive a biasing solution is to the aforementioned variations, the better.
    4) Versatility - the biasing scheme must accommodate a number of operational states via appropriate adjustment of the FET Ids:

        a) saturated, high power state (high Ids)
        b) saturated, reduced power state (medium Ids)
        c) linear, low power state (minimal Ids)
        d) standby/Rx (receiving) state - no input/output (FET pinched off)

5) Enable/disable function - TDD operation and power save features require that the FET be transitioned quickly (within several μs) from the Rx/Standby mode to one of the other three transmission modes.

Existing solutions to the FET biasing problem include an open loop method, which involves adjusting the gate electrode voltage. Since direct measurement of the source-drain current is not easily achieved, the gate electrode voltage Vg is tuned while a more readily measurable parameter, such as output power, is observed. However, this approach is particularly vulnerable to the thermal runaway problem due to lack of feedback.

Such an open loop method involves using a read-only memory to store gate bias voltage data for selection depending on the type of FET used, with a D/A converter to convert the digital value to an analogue voltage for application to the gate electrode, as described in US Patent 5,278,517 to Fujita.

Another solution to the FET biasing problem is a closed loop approach, which provides feedback via a sensing resistor and error amplifier as a direct method of voltage tracking for setting the desired Ids and maintaining this setting over a wide temperature range. This approach, however, requires tracking of the error and when the power is first applied, the integrator delay allows for the possibility of a destructive surge in source-drain current. The integrator delay also prevents rapid transitions between operating modes, and a voltage reference adjustment is needed.

Examples of a direct control, closed loop approach to FET biasing so as to maintain the operating point are described in US Patents 5,442,322 to Kornfeld, 5,585,746 to Franke, and Japanese patent JP 09121126 A, to Oki Electric Ind. Co. Ltd.

As described above, in light of the many problems associated with biasing the FET in applications where there are different output power levels and rapid mode switching, it would be desirable to provide easily controllable FET biasing and insure safe operation despite temperature and loading fluctuations.

SUMMARY OF THE INVENTION

Accordingly, it is a principal object of the present invention to overcome the disadvantages of the prior art FET biasing methods, and provide a novel closed loop FET biasing circuit featuring a standard logic control format for operational mode switching between operating states of a FET power amplifier.

In accordance with a preferred embodiment of the present invention, there is provided a FET gate bias control device for configuring a gate bias circuit in a FET power amplifier to accommodate a broad range of output power levels, wherein the configuration is responsive to a command which establishes a FET bias condition, the FET power amplifier having a source-drain voltage circuit providing a source-drain voltage between the source and drain electrodes, said FET gate bias control device comprising:

  a voltage source means for providing a predetermined voltage in the source-drain voltage circuit;
  a plurality of fixed resistors being connectable to provide a selectable range of resistance values in the source-drain voltage circuit;
  controllable switching means for connecting said plurality of fixed resistors to select a particular resistance value corresponding to one of four predetermined amplifier operating modes, said selected resistance value establishing a source-drain current level associated with a selected one of said predetermined amplifier operating modes; and
  control means for controlling said switching means in response to the command, to select said amplifier operating mode.

In the preferred embodiment, the gate bias control device of the present invention comprises a circuit having a controllable switching unit which connects a pair of resistors in the source-drain voltage circuit individually or in parallel to provide a multiple of resistance values each corresponding to one of four amplifier operating modes.

The controllable switching unit responds to a set of logic control signals, and therefore greatly simplifies the transition between operating modes, while maintaining FET bias conditions which insure operational stability without problems associated with temperature and loading fluctuations.

Other features and advantages of the invention will become apparent from the following drawings and description.

BRIEF DESCRIPTION OF THE DRAWINGS

For a better understanding of the invention with regard to the embodiments thereof, reference is made to the accompanying drawings, in which like numerals designate corresponding sections or elements throughout, and in which:

  Fig. 1 is a state diagram illustrating the modes of operation of a power amplifier using a FET, applied in a telecommunications application;

Figs. 2-3 are prior art block diagrams showing, respectively, open loop and closed loop FET bias voltage control;

Fig. 4 is an electronic schematic diagram showing a preferred embodiment of a closed loop, resistor tracking circuit providing FET bias voltage control, in accordance with the principles of the present invention; and

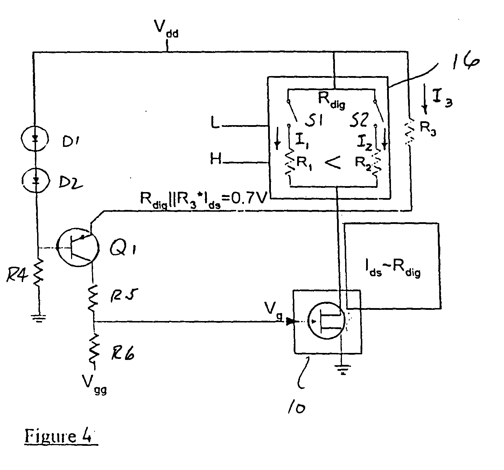

Table 1 summarises the operational states of the circuit shown in Fig. 4.

## DETAILED DESCRIPTION OF THE PREFERRED EMBODIMENT

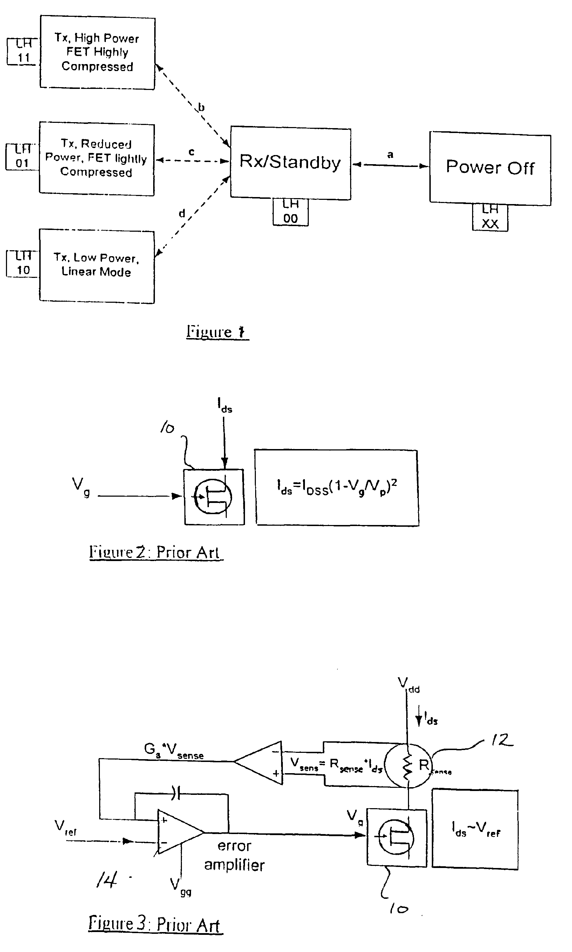

Referring now to Fig. 1, there is shown a state diagram illustrating the modes of operation of a FET power amplifier, applied in a telecommunications application. In order to meet the versatility requirements described in the background to the invention, the biasing scheme must accommodate a number of operational states via appropriate adjustment of the FET Ids from a power off mode, to a standby/Rx (receiving) state -transition (a).

An enable/disable function of the telecommunications unit, having TDD operation and power save features, requires that the FET be transitioned quickly (within several μs) from the Rx/Standby mode to one of the other three transmission modes, noted as transitions b, c and d in the state diagram of Fig. 1.

Each of the transitions b, c and d is from the standby/Rx state to a transmitting state a follows:

Transition- (b) to saturated, high power state (high Ids);

(c) to saturated, reduced power state (medium Ids);

(d) to linear, low power state (minimal Ids).

In Figs. 2 and 3, there are shown prior art techniques for biasing a FET 10 in electronic circuits, and these prior art techniques are now discussed.

In Fig. 2, there is shown a prior art open loop method, which involves adjusting the gate electrode voltage Vg with a potentiometer, or adjusting it using a microprocessor-controlled D/A converter, or adjusting it using a pulse-width modulator with a low pass filter to provide an adjustable analogue output. Direct measurement of Ids is impractical, therefore the gate electrode voltage Vg is tuned while a more readily measurable parameter, such as output power, is observed. Settings for D/A converters or pulse-width modulators (PWM) can be stored in memory, thus meeting the versatility requirement. The parameters affecting Ids are given in the equation:

$$Ids = I_{DSS} (1-Vg/Vp)^2$$

Where Vp = pinch off voltage, i.e., the gate voltage which shuts off the FET, and

$I_{DSS}$ = maximum current drain when gate voltage is zero.

While this circuit compensates for device and power supply variations, it does not directly address the other requirements. It is particularly vulnerable to the thermal runaway problem due to the lack of feedback.

In Fig. 3, there is shown a prior art closed loop approach, which provides feedback via a sensing resistor 12 and error amplifier 14 as a direct method of voltage tracking for setting the desired Ids and maintaining this setting over a wide temperature range. This approach, however, suffers from the following drawbacks:

1) No 'Power on' Control - on transition (a) from an off state to the receiver standby mode, before the integrator can track the error, a destructive surge of Ids can be drawn through the FET.

2) The integrator prevents rapid transitions between modes as required by the TDD, TDMA (time division multiple access) application.

3) A D/A converter or PWM circuit is required for adjusting Vref.

Referring now to Fig. 4, there is shown an electronic schematic diagram showing a preferred embodiment of a closed loop, resistor-tracking circuit providing FET bias voltage control, in accordance with the principles of the present invention.

The tracking circuit of Fig. 4 features a pair of series-connected diodes D1, D2 in a voltage divider arrangement with resistor R4, connected to provide a base input voltage to transistor Q1. The collector leg has a voltage divider comprising resistors R5, R6 to Vgg which adjusts the FET gate bias voltage. A pair of parallel-connected resistors R1, R2 forms a digitally-controlled resistor 16 (Rdig) having digital switches (S1,S2) which enable standard logic to control its operation using logic input signals L, H.

In operation, diodes D1, D2 and transistor Q1 are biased in the active mode such that a 0.7V drop is imposed across the parallel combination of resistors Rdig and R3. The digital switches in Rdig can be implemented using a dual, p-channel MOSFET, which has a very low ON resistance, on the order of a few tenths of an ohm. Depending on the logic implementation chosen, pulldown/pull-up resistors (not shown) connected on the input signal logic lines L and H guarantee that in transition (a), the digital switches S1, S2 remain open, thus protecting the FET, and solving the problem associated with a maximum $I_{DSS}$ surge, which could cause the FET to self-destruct from oscillations and inability to dissipate the resultant heat build up.

In the standby/Rx mode, the digitally-controlled resistor Rdig is very large, effectively disabling the power amplifier. Transistor Q1 is kept in the active mode by resistor R3, which has a value in the range of hundreds of ohms, allowing for fast (b), (c) and (d) transitions, and solves the transition delay problems. For each Rdig value established, the voltage divider in the collector leg of Q1 adjusts the FET gate bias voltage to accommodate the Ids dictated by the value of Rdig. This feedback mechanism renders the circuit insensitive to variation in FET pinch off characteristics, thus solving the problems associated with manufacturing the FET so as to make it independent of device parameter variations. In addition, it solves the thermal runaway problem.

The level of Ids can be controlled by Rdig, and this provides the versatility required in design of the power amplifier, for the operational states outlined in the background. The value of resistor R3 is chosen so that the current through resistor R3 (I3) is on the order of a few milliamps, while the current through the digital switches (I1, I2) can be adjusted to be on the order of a few hundred milliamps. These operational states can be summarised as shown in Table 1:

| State | L | H | $R_{dig}$ | $I_{ds}$ |
|---|---|---|---|---|
| Standby/Rx | 0 | 0 | $\infty$ | $I_3$ |
| Tx, Linear, Low Power | 1 | 0 | R2 | $I_2 + I_3$ |
| Tx, Saturated, Reduced Power | 0 | 1 | R1 | $I_1 + I_3$ |
| Tx, Saturated, High Power | 1 | 1 | R1‖R2 | $I_1 + I_2 + I_3$ |

In summary, the present invention provides a gate bias control circuit comprising a controllable switching unit responsive to a set of logic control signals, to greatly simplify the transition between FET operating modes, while maintaining FET bias conditions which insure operational stability without problems associated with temperature and loading fluctuations.

Having described the invention with regard to certain specific embodiments thereof, it is to be understood that the description is not meant as a limitation, since further modifications may now suggest themselves to those skilled in the art, and it is intended to cover such modifications as fall within the scope of the appended claims.

## Claims

1. A FET gate bias control device for configuring a gate bias circuit in a FET power amplifier to accommodate a broad range of output power levels, wherein the configuration is responsive to a command which establishes a FET bias condition, the FET power amplifier having a source-drain voltage circuit providing a source-drain voltage between the source and drain electrodes, said FET gate bias control device comprising:

   a voltage source means for providing a predetermined voltage in the source-drain voltage circuit;
   a plurality of fixed resistors being connectable to provide a selectable range of resistance values in the source-drain voltage circuit,
   controllable switching means for connecting said plurality of fixed resistors to select a particular resistance value corresponding to one of a plurality of predetermined amplifier operating modes, said selected resistance value establishing a source-drain current level associated with a selected one of said predetermined amplifier operating modes; and
   control means for controlling said switching means in response to the command, to select said amplifier operating mode.

2. The device of claim 1 further comprising a voltage divider arranged to establish a FET gate bias voltage in accordance with said selected amplifier operating mode.

3. The device of claim 2 wherein said FET gate bias voltage associated with said selected amplifier operating mode insures operational stability without temperature and loading fluctuations.

4. The device of claim 1 wherein said controllable switching means comprises at least one path having a fixed resistor arranged in series with a switching element, said parallel path being connected in the source-drain voltage circuit to establish said selectable range of resistance values.

5. The device of claim 1 wherein said controllable switching means comprises a plurality of parallel paths each having a fixed resistor arranged in series with a switching element, said parallel paths being connected in the source-drain voltage circuit to establish said selectable range of resistance values.

6. The device of claim 5 wherein each of said switching elements comprises a MOSFET.

7. The device of claim 6 wherein each of said MOSFETs is controllable by a logic circuit which controls MOSFET switching between said amplifier operating modes while insuring each of said MOSFETs normally remains open during power ON/OFF transitions.

8. The device of claim 7 wherein said logic circuit comprises at least one of pull-up/pulldown resistors connected to input logic signal lines to maintain said MOSFETs normally open.

9. The device of claim 1 wherein said amplifier operating modes comprise a standby mode, a linear low power mode, a saturated low power mode, and a saturated high power mode.

10. The device of claim 9 applied in a time division duplex (TDD) telecommunications system wherein rapid transition between said operating modes provides a power saving feature.

11. A method of configuring a gate bias circuit in a FET power amplifier to accommodate a broad range of output power levels, wherein the configuration is responsive to a command which establishes a FET bias condition, the FET power amplifier having a source-drain voltage circuit providing a source-drain voltage between the source and drain electrodes, said method comprising the steps of:

   providing a predetermined voltage in the source-drain voltage circuit;
   providing a plurality of fixed resistors being connectable to provide a selectable range of resistance values in the source-drain voltage circuit;
   connecting said plurality of fixed resistors to select a particular resistance value corresponding to one of a plurality of predetermined amplifier operating modes, said selected resistance value establishing a source-drain current level associated with a selected one of said predetermined amplifier operating modes; and
   controlling performance of said connecting step in response to the command, to select said amplifier operating mode.

12. The method of claim 11 further comprising the step of providing a voltage divider arranged to establish a FET gate bias voltage in accordance with said selected amplifier operating mode.

13. The method of claim 12 wherein said FET gage bias voltage associated with said selected amplifier operating mode insures operational stability without temperature and loading fluctuations.

14. The method of claim 11 wherein said connecting step is performed by a controllable switching means comprising switching elements responsive to a logic circuit which controls switching between said amplifier operating modes while insuring said switching elements normally remain open during power ON/OFF transitions.

15. The method of claim 11 wherein said controllable switching means comprises a plurality of parallel paths each having a fixed resistor arranged in series with one of said switching elements, said parallel paths being connected in the source-drain voltage circuit to establish said selectable range of resistance values.

16. The method of claim 11 wherein said amplifier operating modes comprise a standby mode, a linear low power mode, a saturated low power mode, and a saturated high power mode.

17. The method of claim 16 applied in a time division duplex (TDD) telecommunications system wherein rapid transition between said operating modes provides a power saving feature.

Figure 1

$$I_{ds} = I_{DSS}(1 - V_g/V_p)^2$$

Figure 2: Prior Art

$G_a * V_{sense}$

$V_{sens} = R_{sense} * I_{ds}$

$I_{ds} \sim V_{ref}$

$V_{ref}$

$V_g$

error amplifier

$V_{gg}$

Figure 3: Prior Art

7

Figure 4

## EUROPEAN SEARCH REPORT

**European Patent Office**

Application Number

EP 00 20 0820

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | GB 2 332 997 A (SAMSUNG ELECTRONICS CO LTD) 7 July 1999 (1999-07-07) * the whole document * | 1-8, 10-15,17 | H03F1/02 H03F1/30 |
| A | DE 196 04 239 A (ALPS ELECTRIC CO LTD) 22 August 1996 (1996-08-22) * column 4, line 34 - column 9, line 10; figures 1,2 * | 2,3 | |
| A | SMELY D ET AL: "IMPROVEMENT OF EFFICIENCY AND LINEARITY OF A HARMONIC CONTROL AMPLIFIER BY ENVELOPE CONTROLLED BIAS VOLTAGE" IEEE MTT-S INTERNATIONAL MICROWAVE SYMPOSIUM DIGEST,US,NEW YORK, NY: IEEE, 7 June 1998 (1998-06-07), pages 1667-1670, XP000825096 ISBN: 0-7803-4472-3 * page 1668 - page 1669; figure 2 * | 1-17 | |
| A | US 3 984 783 A (BICKLEY ROBERT H) 5 October 1976 (1976-10-05) * abstract; figures 1-3 * | 9,16 | TECHNICAL FIELDS SEARCHED (Int.Cl.7) H03F |

The present search report has been drawn up for all claims

| Place of search | Date of completion of the search | Examiner |
|---|---|---|
| THE HAGUE | 10 August 2000 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 00 20 0820

This annex lists the patent family members relating to the patent documents cited in the above-mentioned European search report.
The members are as contained in the European Patent Office EDP file on
The European Patent Office is in no way liable for these particulars which are merely given for the purpose of information.

10-08-2000

| Patent document cited in search report | | Publication date | Patent family member(s) | | Publication date |
|---|---|---|---|---|---|
| GB 2332997 | A | 07-07-1999 | CN | 1228004 A | 08-09-1999 |
| | | | JP | 3012230 B | 21-02-2000 |
| | | | JP | 11289577 A | 19-10-1999 |
| DE 19604239 | A | 22-08-1996 | JP | 8222962 A | 30-08-1996 |
| US 3984783 | A | 05-10-1976 | NONE | | |

For more details about this annex : see Official Journal of the European Patent Office, No. 12/82